# EUROPEAN PATENT APPLICATION

(11) **EP 1 798 307 A1**
(43) Date of publication of application: **20.06.2007**
(21) Application number: 06256325.9
(22) Date of filing: 12.12.2006
(51) Int. Cl.: C23C 16/22

(54) **Organometallic composition**

(30) Priority: 19.12.2005 US 751603 P; 22.12.2005 US 316466
(71) Applicant: Rohm and Haas Electronic Materials LLC, Marlborough, MA 01752 (US)
(72) Inventor: Shenai-Khatkhate, Deodata Vinayak, Danvers, MA 01923 (US); Woelk, Egbert, North Andover, MA 01845 (US)
(74) Representative: Kent, Venetia Katherine

(57) **Abstract**

Compositions including germanium compounds suitable for use as vapor phase deposition precursors for germanium-containing films are provided. Methods of depositing films containing germanium using such compositions are also provided. Such germanium-containing films are particularly useful in the manufacture of electronic devices.

## Description

The present invention relates generally to the field of organometallic compounds. In particular, the present invention relates to the vapor phase deposition of a germanium film.

Metal films may be deposited on surfaces, such as non-conductive surfaces, by a variety of means such as chemical vapor deposition ("CVD"), physical vapor deposition ("PVD"), and other epitaxial techniques such as liquid phase epitaxy ("LPE"), molecular beam epitaxy ("MBE"), chemical beam epitaxy ("CBE") and atomic layer deposition ("ALD"). Chemical vapor deposition processes, such as metalorganic chemical vapor deposition ("MOCVD"), deposit a metal layer by decomposing organometallic precursor compounds at elevated temperatures, i.e., above room temperature, either atmospheric pressure or at reduced pressures. A wide variety of metal-containing films may be deposited using these processes.

For semiconductor and electronic device applications, these organometallic precursor compounds must be highly pure and be substantially free of detectable levels of metalloid and metallic impurities, such as silicon and zinc, as well as oxygenated impurities. Oxygenated impurities are typically present from the solvents used to prepare the organometallic compounds, and are also present from other adventitious sources of moisture or oxygen.

For certain applications where high speed and frequency response of an electronic device is desired, the introduction of germanium into a silicon device is necessary to obtain the desired functionality. In a heterojunction bipolar transistor ("HBT"), a thin silicon-germanium layer is grown as the base of a bipolar transistor on a silicon wafer. The silicon-germanium HBT has significant advantages in speed, frequency response, and gain when compared to a conventional silicon bipolar transistor. The speed and frequency response of a silicon-germanium HBT are comparable to more expensive gallium-arsenide HBTs.

The higher gain, speeds, and frequency response of silicon-germanium HBTs are due to certain advantages of silicon-germanium, for example, narrower band gap and reduced resistivity. Silicon-germanium may be epitaxially grown on a silicon substrate using conventional silicon processing and tools, allowing device properties, such as the energy band structure and carrier mobility, to be engineered. For example, grading the concentration of germanium in the silicon-germanium base builds into the HBT device an electric field or potential gradient, which accelerates the carriers across the base, thereby increasing the speed of the HBT device compared to a silicon-only device. A common method for fabricating silicon and silicon-germanium devices is by CVD, such as by reduced pressure CVD ("RPCVD").

Surface roughness is a problem of growing strained silicon layers, such as silicon-germanium layers. Silicon-germanium layers typically show a cross-hatched surface morphology with trenches and ridges on the surface. Such surface roughness is due to the buried dislocation that is present in a silicon-germanium layer. Typically, this surface roughness is removed by planarizing the film, such as by using chemical mechanical planarization. This added planarization step greatly increases the cycle time and costs of manufacturing strained silicon films. It is desirable to produce silicon-germanium layers having reduced surface roughness, thereby reducing the need for planarization of such silicon-germanium layers.

U.S. Patent Application Publication No. 2004/0197945 (Woelk et al.) discloses the deposition of a germanium-containing film using two or more germanium compounds in the vapor phase, where one of the germanium compounds is a halogermane. This approach is effective in depositing germanium films with reduced particle formation on the reactor walls, resulting in reduced reactor maintenance. This application does not specifically address the problem of surface roughness.

The present invention provides a method of depositing a silicon-germanium layer having reduced surface roughness as compared to conventional processes for depositing such layers. In one embodiment, the present invention provides a method of depositing a film including germanium on a substrate including the steps of: a) conveying in a gaseous phase a germanium compound and an additive compound chosen from a gas phase modifier and a surface modifier, wherein the germanium compound has the formula GeA₄ wherein each A is independently chosen from hydrogen, halogen, alkyl, alkenyl, alkynyl, aryl, amino, dialkylamino, and dialkylaminoalkyl, to a deposition chamber containing the substrate, and wherein the additive compound does not include germanium; b) decomposing the germanium compound in the deposition chamber; and c) depositing the film including germanium on the substrate.

In another embodiment, the present invention provides a vapor delivery device including a vessel having an elongated cylindrical shaped portion having an inner surface having a cross-section, a top closure portion and a bottom closure portion, the top closure portion having an inlet opening for the introduction of a carrier gas and an outlet opening, the elongated cylindrical shaped portion having a chamber containing a germanium compound and an additive compound chosen from a gas phase modifier and a surface modifier; the inlet opening being in fluid communication with the chamber and the chamber being in fluid communication with the outlet opening; wherein the germanium compound has the formula GeA₄ wherein each A is independently chosen from hydrogen, halogen, alkyl, alkenyl, alkynyl, aryl, amino, dialkylamino, and dialkylaminoalkyl, and wherein the additive compound does not include germanium.

Also provided by the present invention is an apparatus including a first vapor delivery device including a germanium compound of the formula GeA₄ wherein each A is independently chosen from hydrogen, halogen, alkyl, alkenyl, alkynyl, aryl, amino, dialkylamino, and dialkylaminoalkyl; and a second vapor delivery device including an additive compound chosen from a gas phase modifier and a surface modifier, wherein the additive compound does not include germanium, the first and second vapor delivery devices capable of providing the germanium compound and the additive compound in the vapor phase to a deposition chamber.

Still further, the present invention provides a device including a germanium-containing layer of the formula MₓGe_{y}, wherein M is a metal or metalloid, x = 0.5 - 0.99, y = 0.01 - 0.5, x + y = 1, wherein the layer has a short range average surface roughness of < 1 nm, and a long range average surface roughness of < 5 nm, and wherein the germanium-containing layer has a threading dislocation density of < 4 x 10⁴ cm⁻² when y = 0.2. M is different from germanium. In one embodiment, M is silicon. Typically, y = 0.05 - 0.45, and more typically 0.1 - 0.4.

As used throughout this specification, the following abbreviations shall have the following meanings, unless the context clearly indicates otherwise: ° C = degrees centigrade; kPa = kilopascals; g = gram; ca. = approximately; cm = centimeter; nm = nanometer; and µm = micron = micrometer.

"Halogen" refers to fluorine, chlorine, bromine and iodine and "halo" refers to fluoro, chloro, bromo and iodo. Likewise, "halogenated" refers to fluorinated, chlorinated, brominated and iodinated. "Alkyl" includes linear, branched and cyclic alkyl. Likewise, "alkenyl" and "alkynyl" include linear, branched and cyclic alkenyl and alkynyl, respectively. The term "SiGe" refers to silicon-germanium. "Films" and "layers" are used interchangeably throughout this specification. As used herein, "CVD" is intended to include all forms of chemical vapor deposition such as MOCVD, MOVPE, OMVPE, OMCVD and RPCVD. The articles "a" and "an" refer to the singular and the plural.

Unless otherwise noted, all amounts are percent by weight and all ratios are molar ratios. All numerical ranges are inclusive and combinable in any order except where it is clear that such numerical ranges are constrained to add up to 100%.

A wide variety of germanium compounds may be used in the present invention. In general, the germanium compound has the formula GeA₄ wherein each A is independently chosen from hydrogen, halogen, alkyl, alkenyl, alkynyl, aryl, amino, dialkylamino, and dialkylaminoalkyl. The germanium compound may be heteroleptic or homoleptic. By "heteroleptic germanium compound" is meant a germanium compound having mixed groups, i.e., a germanium compound having 4 groups where at least one group is different from the other groups. By "homoleptic germanium compound" is meant a germanium compound having 4 groups that are the same.

The germanium compound may contain a wide variety of alkyl, alkenyl, alkynyl and aryl groups. Suitable alkyl groups include, without limitation, (C₁-C₁₂)alkyl, typically (C₁-C₆)alkyl and more typically (C₁-C₄)alkyl. Exemplary alkyl groups include, but are not limited to, methyl, ethyl, n-propyl, iso-propyl, n-butyl, iso-butyl, sec-butyl, tert-butyl, pentyl, cyclopentyl, hexyl, and cyclohexyl. More typically, suitable alkyl groups include ethyl, iso-propyl, and tert-butyl. Suitable alkenyl groups include, without limitation, (C₂-C)₂)alkenyl, typically (C₂-C₆)alkenyl and more typically (C₂-C₄)alkenyl. Exemplary alkenyl groups include vinyl, allyl, methallyl and crotyl. Typical alkynyl groups include, without limitation, (C₂-C₁₂)alkynyl, typically (C₂-C₆)alkynyl and more typically (C₂-C₄)alkynyl. Suitable aryl groups are (C₆-C₁₀)aryl, including, but not limited to, phenyl, tolyl, xylyl, benzyl and phenethyl. When two or more alkyl, alkenyl, alkynyl or aryl groups are present, such groups may be the same or different.

Typical amino (NR¹R²) groups for R include, but are not limited to, dimethylamino, diethylamino, di-iso-propylamino, ethylmethylamino, iso-propylamino, and tert-butylamino. However, other suitable amino groups may be used.

Any of the above alkyl, alkenyl, alkynyl and aryl groups may optionally be substituted with one or more amino (NR³R⁴) groups, wherein R³ and R⁴ are independently chosen from H, alkyl, alkenyl, alkynyl and aryl. By "substituted" it is meant that one or more hydrogens on the alkyl, alkenyl, alkynyl or aryl group is replaced with one or more NR³R⁴ groups. Exemplary alkyl substituted with NR³R⁴ groups include, without limitation, dimethylamino-methyl ((CH₃)₂N-CH₂-), dimethylamino-ethyl ((CH₃)₂N-C₂H₄-), diethylamino-ethyl ((C₂H₅)₂N-C₂H₄-), dimethylamino-propyl ((CH₃)₂N-C₃H₆-), and diethylamino-propyl ((C₂H₅)₂N-C₃H₆-).

A wide variety of halogermanium compounds may be used, such as, but not limited to, tetrahalogermanes and halogermanium compounds of the formula X¹₄₋ₐGeRₐ, wherein each R is independently chosen from H, alkyl, alkenyl, alkynyl, aryl and NR¹R²; wherein R¹ and R² are independently chosen from H, alkyl, alkenyl, alkynyl and aryl; each X¹ is independently halogen; and a = 0-3. The tetrahalogermanes have the formula GeX¹₄, wherein each X' is independently a halogen. When two or more halogens are present in the halogermanium compounds, such halogens may be the same or different.

Exemplary halogermanium compounds include, without limitation: tetrahalogermanium compounds such as tetrachloro germane, tetrafluoro germane, tetrabromo germane, tetraiodo germane, chloro tribromo germane, dichloro dibromo germane, trichloro bromo germane, trichloro iodo germane, dichloro diiodo germane, trichloro iodo germane, tribromo iodo germane, dibromo diiodo germane, bromo triiodo germane, dichloro bromo iodo germane, chloro dibromo iodo germane, chloro bromo diiodo germane, trichloro fluoro germane, dichloro difluoro germane, chloro trifluoro germane, tribromo fluoro germane, dibromo difluoro germane, bromo trifluoro germane, iodo trifluoro germane, diiodo difluoro germane, triiodo fluoro germane, chloro bromo iodo fluoro germane, dichloro bromo fluoro germane, chloro dibromo fluoro germane, dibromo iodo fluoro germane, bromo diiodo fluoro germane, dichloro iodo fluoro germane and chloro diiodo fluoro germane; iso-propyl (dimethylamino) germanium dichloride; methyl (dimethylamino) germanium dichloride; methyl (dimethylamino) germanium dibromide; dichloro (diethylamino) germane; dichloro ethyl (diethylamino) germane; dichloro tert-butyl (diethylamino) germane; dichloro bis(dimethylamino) germane; and chloro ethyl (dimethylaminopropyl) (dimethylamino) germane; dichloro tert-butyl (dimethylamino) germane; chloro di-iso-propyl (dimethylamino) germane; trimethyl germanium chloride; methyl germanium trichloride; trimethyl germanium fluoride; trimethyl germanium bromide; tris(trifluoromethyl) germanium iodide; methyl germanium trifluoride; dimethyl germanium difluoride; dichloro methyl germane; dimethyl germanium dichloride; trimethyl germanium iodide; vinyl germanium trichloride; ethyl germanium trichloride; chloro tert-butyl dimethyl germane; allyl germanium trichloride; tert-butyl germanium trichloride; diethyl germanium dichloride; trimethyl germanium chloride; n-butyl germanium trichloride; trimethyl germanium bromide; di-n-butyl germanium dichloride; phenyl germanium dichloride; tri-n-butyl germanium bromide; tri-n-butyl germanium chloride; and benzyl germanium trichloride. In one embodiment, the germanium compound is a tetrahalogermane.

Other suitable germanium compounds include, without limitation: germane, alkyl germanes such as tetramethyl germane, tetraethyl germane, tetra-n-propyl germane, methyl germane, dimethyl germane, trimethyl germane, ethyl germane, diethyl germane, trimethyl germane, dimethyl diethyl germane, tert-butyl methyl germane, tert-butyl dimethyl germane, tert-butyl trimethyl germane, tert-butyl ethyl germane, tert-butyl diethyl germane, tert-butyl trimethyl germane, tert-butyl iso-propyl germane, methyl tert-butyl iso-propyl germane, iso-propyl germane, di-iso-propyl germane, di-iso-propyl dimethyl germane, tri-iso-propyl germane, tri-iso-propyl methyl germane, di-iso-propyl diethyl germane, iso-butyl germane, di-iso-butyl germane, di-iso-butyl diethyl germane, tri-iso-butyl germane, tri-iso-butyl methyl germane, and di-iso-butyl dimethyl germane; amino germanes such as (dimethylamino) germane, bis-(dimethylamino) germane, methyl (dimethylamino) germane, ethyl (dimethylamino) germane, diethyl (diethylamino) germane, tert-butyl (dimethylamino)germane, tert-butyl bis(dimethylamino) germane, ethyl tert-butyl bis(dimethylamino) germane, iso-propyl (dimethylamino)germane, iso-propyl (diethylamino) germane, di-iso-propyl bis(dimethylamino) germane, n-propyl (dimethylamino) germane, and n-propyl (diethylamino) germane; and halogermanium compounds such as tert-butyl dimethyl germanium chloride, tert-butyl dimethyl germanium bromide, tert-butyl diethyl germanium chloride, tert-butyl diethyl germanium iodide, dimethyl germanium dichloride, trimethyl germanium chloride, trimethyl germanium bromide, tert-butyl germanium trichloride, iso-propyl germanium chloride, iso-propyl germanium trichloride, di-iso-propyl germanium dibromide, iso-propyl dimethyl germanium chloride, iso-propyl methyl germanium dichloride, and iso-propyl dimethyl germanium bromide.

Germanium compounds useful in the present invention are generally commercially available from a variety of sources or may be made by methods described in the art, such as those described in U.S. Pat. Application Pub. No. 2004/0197945. It will be appreciated by those skilled in the art that more than one germanium compound may be used in the present invention.

For use in electronic device manufacture, the germanium compound typically is substantially free of metallic impurities such as zinc and aluminum, and preferably free of zinc and aluminum. Such germanium compounds are also typically substantially free of silicon. By "substantially free" it is meant that the compounds contain less than 0.5 ppm of such impurities, and preferably less than 0.25 ppm. In another embodiment, the present germanium compounds have "5-nines" purity, i.e. a purity of ≥ 99.999%. More typically, the germanium compounds have a purity of "6-nines", i.e. ≥ 99.9999%.

The additive compounds useful in the present invention are chosen from a gas phase modifier and a surface modifier. A wide variety of gas phase modifiers and surface modifiers may be used. The additive compound does not contain germanium. "Gas phase modifier" refers to a compound that enhances the gas phase reactivity of the germanium compound. While not wishing to be bound by theory, it is believed that such gas phase modifiers form or aid in forming gas phase germanium intermediates that decompose at temperatures lower than that of the germanium compound or, alternatively, act as catalysts to decompose the germanium compound in the gas phase. Suitable gas phase modifiers include, but are not limited to, silicon and tin compounds, Group IA compounds, Group IIA compounds, Group IIIA compounds, Group VA compounds, Group IB compounds, Group IVB compounds, Group VB compounds, Group VIB compounds, Group VIIB compounds, and Group VIII compounds. Particularly suitable additive compounds are those containing one or more of boron, aluminum, indium, gallium, tin, tungsten, titanium, molybdenum, ruthenium, platinum, palladium, nitrogen, arsenic, phosphorus, antimony and bismuth. Exemplary Group IA compounds include, without limitation, alkyllithium compounds, alkylsodium compounds, sodium halides, and potassium halides such as potassium fluoride. Exemplary Group IIA compounds include, but are not limited to, alkylberylium compounds, cyclopentadienylmagnesium compounds, halogenated compounds of one or more of calcium, barium and strontium. Exemplary Group IIIA compounds include alkylaluminum compounds, alkylindium compounds, alkylgallium compounds, haloaluminum compounds, haloindium compounds, halogallium compounds, alkylboron compounds, and haloboron compounds. Exemplary Group VA compounds include without limitation, alkylnitrogen compounds, alkylphosphorus compounds and alkylarsenic compounds. Exemplary Group IB compounds include, but are not limited to, cuprous halides, silver cyclopentadienides. Exemplary Group VB compounds include, without limitation, chlorides and bromides of vanadium, niobium and tantalum. Exemplary Group VIB compounds include, but are not limited to, halides of chromium, molybdenum and tungsten. Exemplary Group VIIB compounds include, without limitation, cyclopentadienylmanganese, manganese tetrabromide, and manganese tetrachloride. Exemplary Group VIII compounds include, but are not limited to, cyclopentadienyl and chloride compounds of iron, ruthenium, cobalt, rhodium, iridium, nickel, palladium, and platinum. Exemplary gas phase modifiers include, without limitation, boron tribromide, tert-butylamine, unsymmetrical dimethylhydrazine, phosphine, tert-butylphosphine, arsine, tert-butylarsine, palladium cyclopentadienides, platinum cyclopentadieneides, dicyclopentadienyl ruthenium, ethylbenzyl molybdenum, tungsten compounds, and titanium compounds.

"Surface modifier" refers to a compound that reduces the roughness of the growing silicon-containing film. While not wishing to be bound by theory, it is believed that such surface modifiers provide a surfactant effect on the growing germanium-containing film or, alternatively, as an etchant to modulate the surface topography of the germanium-containing film. Suitable surface modifiers include, but are not limited to, Group IIIA compounds, Group VA compounds, tin compounds such as stannic chloride, lead compounds, hydrogen halides, and hydrido halides of silicon. Any of the Group IIIA and Group VA compounds described above are also suitable as surface modifiers. Exemplary Group IIIA and VA compounds include, but are not limited to, gallium trichloride, antimony trichloride, trimethyl antimony, trimethyl bismuth, and trimethyl arsenic. Exemplary hydrogen halides include, without limitation, HCl, HF, HBr, and NaHF₂.

Additive compounds are generally commercially available from a variety of sources. It will be appreciated that more than one additive compound may be used in the present invention.

The germanium compounds may be solids, liquids or gasses. Likewise, the additive compounds may be solids, liquids or gasses. When the germanium compound and the additive compound are solids, liquids or gases, they may be combined into a single delivery device, such as a bubbler. For example, two or more gases, two or more liquids, two or more solids, or a combination of liquid and solid compounds may be combined into a single delivery device. Alternatively, multiple delivery devices may be used. For example, the germanium compound may be added to a first delivery device and the additive compound may be added to a second delivery device. It will be appreciated by those skilled in the art that either the first delivery device, the second delivery device or both delivery devices contain more than one germanium compound and more than one additive compound, respectively. It will be further appreciated that more than two delivery devices may be used. When one or more gaseous germanium compounds, such as germane, are to be used with one or more solid or liquid additive compounds compounds, such as gallium trichloride, it is preferred that the gaseous germanium compounds are not in the same delivery device as the solid or liquid additive compound.

In one embodiment, films including germanium are typically deposited by first placing the desired germanium compound, i.e. source compound or precursor compound, in a vapor delivery device having an outlet connected to a deposition chamber. A wide variety of vapor delivery devices may be used, depending upon the particular deposition apparatus used. For solid germanium compounds and solid additive compounds, the devices disclosed in U.S. Patent Nos. 6,444,038 (Rangarajan et al.) and 6,607,785 (Timmons et al.), as well as other designs, may be used. For liquid germanium compounds and liquid additive compounds, the devices disclosed in U.S. Patent Nos. 4,506,815 (Melas et al) and 5,755,885 (Mikoshiba et al) may be used, as well as other liquid precursor vapor delivery devices. Solid source compounds are typically vaporized or sublimed prior to transportation to the deposition chamber.

In another embodiment, the germanium compound may be placed in a first vapor delivery device and the additive compound may be placed in a second vapor delivery device. Each vapor delivery device is then connected to the same deposition apparatus. Each of the compounds is then conveyed from its respective delivery device into the deposition chamber to provide the germanium compound and the additive compound in the vapor phase. It will be appreciated that more than two vapor delivery devices containing germanium and/or additive compounds may be used in order to provide more than two germanium compounds and/or more than two additive compounds in the vapor phase. In a further embodiment, the germanium compound and additive compound are placed in a single delivery device.

In a still further embodiment, a germanium compound, such as germane or germanium tetrachloride, is placed in a first vapor delivery device and an additive compound is placed in a second vapor delivery device. Both the germanium compound and the additive compound are delivered to a deposition chamber in the vapor phase. Such germanium compound and additive compound, in one embodiment, may react in the vapor phase to form a germanium source. In this way, a stable concentration of germanium source in the vapor phase is provided.

Alternatively, the additive compound may temporarily deposit on the surface of the growing germanium-containing film, and be displaced by a subsequently deposited germanium atom. In this way, a surface having reduced roughness is obtained. In yet a further alternative, the additive compound may be incorporated into the growing film. Provided that the additive compound is in a sufficiently low amount, such incorporation may have little or no effect on the final germanium-containing film.

In general, the additive compound may be present in the vapor phase in an amount of up to 0.25 mole% based on the moles of the germanium compound in the vapor phase. Typically, the amount of the additive compound in the vapor phase is from 0.01-0.25 mole%, more typically from 0.05-0.20 mole% and still more typically from 0.08-0.15 mole%.

The present invention also provides a vapor delivery device for feeding a fluid stream saturated with a germanium compound suitable for depositing a germanium-containing film to a chemical vapor deposition system including a vessel having an elongated cylindrical shaped portion having an inner surface having a cross-section, a top closure portion and a bottom closure portion, the top closure portion having an inlet opening for the introduction of a carrier gas and an outlet opening, the elongated cylindrical shaped portion having a chamber containing the germanium compound and the additive compound described above; the inlet opening being in fluid communication with the chamber and the chamber being in fluid communication with the outlet opening. In another embodiment, the present invention provides an apparatus for chemical vapor deposition of germanium-containing films including one or more of the vapor delivery devices described above. Such vapor delivery devices may be used to provide the germanium and additive compounds in the vapor phase to a single deposition chamber or to a plurality of deposition chambers.

The germanium and additive compounds are typically transported to the deposition chamber by passing a carrier gas through the vapor delivery device. Suitable carrier gasses include nitrogen, hydrogen, and mixtures thereof. When the germanium and/or additive compound is a liquid, the carrier gas is introduced below the surface of the compound, and bubbles up through the compound to the headspace above it, entraining or carrying vapor of the compound in the carrier gas. When the germanium compound and/or additive compound is a solid, the carrier gas may be introduced to the top of the compound in the delivery device and travel through the solid compound to a space below the compound, entraining or carrying vapor of the compound in the carrier gas. The entrained or carried vapor then passes into the deposition chamber.

The deposition chamber is typically a heated vessel within which is disposed at least one, and possibly many, substrates. The deposition chamber has an outlet, which is typically connected to a vacuum pump in order to draw by-products out of the chamber and to provide a reduced pressure where that is appropriate. MOCVD can be conducted at atmospheric or reduced pressure. The deposition chamber is maintained at a temperature sufficiently high to induce decomposition of the source compound. The deposition chamber temperature is typically from 200° to 1200° C, the exact temperature selected being optimized to provide efficient deposition. Optionally, the temperature in the deposition chamber as a whole can be reduced if the substrate is maintained at an elevated temperature, or if other energy such as radio frequency ("RF") energy is generated by an RF source.

Suitable substrates for deposition, in the case of electronic device manufacture, may be silicon, gallium arsenide, indium phosphide, sapphire, and the like. Such substrates are particularly useful in the manufacture of integrated circuits.

Deposition is continued for as long as desired to produce a film including germanium having the desired properties. Typically, the film thickness will be from several tens of nanometers to several hundreds of micrometers.

The present invention further provides a method for manufacturing an electronic device including the step of depositing a film including germanium on an electronic device substrate including the steps of: a) conveying in a gaseous phase a germanium compound and an additive compound chosen from a gas phase modifier and a surface modifier, wherein the germanium compound has the formula GeA₄ wherein each A is independently chosen from hydrogen, halogen, alkyl, alkenyl, alkynyl, aryl, amino, dialkylamino, and dialkylaminoalkyl, to a deposition chamber containing the substrate, and wherein the additive does not include germanium; b) decomposing the germanium compound in the deposition chamber; and c) depositing the film including germanium on the substrate.

The present invention is particularly suitable for the deposition of germanium-containing films, such as SiGe films. When used in Bipolar CMOS or BiCMOS, the SiGe film is used as the base of a high frequency HBT and typically has a thickness of 40 to 80 nm. The substrate for the deposition of this SiGe base film and the subsequent Si collector film is a highly structured silicon wafer with the CMOS circuitry mostly finished. When used in strained silicon or s-Si, the SiGe film typically has a thickness of 3 to 5 micrometers on a plain silicon wafer. Subsequent to the growth of the SiGe film a thin (20 nm) Si film is grown. This silicon film adopts the crystal lattice of the underlying SiGe layer (strained silicon). Strained silicon shows much faster electrical responses than regular silicon.

In another embodiment, a method for fabricating a device containing a group of silicon-germanium layers is illustrated by the steps of: i) providing a substrate including a surface layer of a Group IV element, ii) maintaining the substrate at a temperature ranging from 400° C to 1200° C, iii) forming a layer of Si₁₋ₓGeₓ, where x ranges from 0 to 0.50, on the substrate by MOCVD using the method described above; iv) maintaining the substrate at about the temperature of step i) and continuing a silicon precursor flow with a flow of the germanium compounds completely switched off, in order to obtain abrupt interfaces, and v) maintaining the substrate at about the temperature of step i), and forming a cap layer of strained silicon, thereby improving the mobility of electrons and speed of the device.

An advantage of the present invention is that germanium-containing films can be obtained that have reduced surface roughness as compared to conventional germanium-containing films. In particular, the present invention provides a device including a germanium-containing layer of the formula MₓGe_{y}, wherein M is a metal or metalloid, x = 0.5 - 0.99, y = 0.01 - 0.5, x + y = 1, wherein the layer has a short range average surface roughness of < 1 nm, and a long range average surface roughness of < 5 nm, and wherein the germanium-containing layer has a threading dislocation density ("TDD") of < 4 x 10⁴ cm⁻² when y = 0.2. In particular, M = silicon. Typically, the TDD is < 1 x 10⁴ cm⁻². Both the short range average surface roughness and long range average surface roughness are determined using atomic force microscopy/optical interferometry using conventional parameters suitable for the particular instrument employed. The short range average surface roughness is determined on a 10 x 10 µm image size. The long range average surface roughness is determined using a 40 x 40 µm image size. TDD is determined using etch pit density which is determined by plain view transmission electron microscopy. Such films also typically have a pile up density of <0.1 cm/cm². Pile up density is determined using etch pitch density which is determined by plain view transmission electron microscopy.

The following examples are expected to illustrate further various aspects of the present invention. All manipulations are performed in an inert atmosphere, typically under an atmosphere of dry nitrogen.

### Example 1

A germanium film is expected to be grown on a sapphire substrate using a conventional delivery device containing a composition including germanium tetrachloride (GeCl₄) and antimony pentachloride (SbCl₅) in a weight ratio (99.0:1.0) attached to a MOCVD apparatus. The delivery device is heated and a carrier gas (H₂ and/or N₂) is passed through the heated delivery device. The carrier gas saturated with formulation components in vapor phase is directed to a deposition chamber containing the sapphire substrate. The deposition chamber is maintained at a temperature sufficient to induce decomposition of the vapor phase germanium compound. A germanium film is expected to be deposited on the sapphire substrate. Deposition is expected to be continued until a desired thickness of the germanium film is achieved. Based on the etch pit density (EPD) measurements, the film is expected to have a TDD of < 1 x 10⁴ cm⁻², and pileup density <0.1 cm/cm². The short range average surface roughness, as measured by atomic force microscopy ("AFM") measurements, is expected to be < 1 Å.

### Example 2

The procedure of Example 1 is repeated except the antimony petachloride is replaced with 1% gallium trichloride (GaCl₃) on weight basis. The film is expected to show surface morphology comparable to that in Example 1.

### Example 3

A group of SiₓGe₍₁₋ₓ₎ epitaxial structures are expected to be grown by MOCVD on (0001) sapphire substrates. A first delivery device containing dichlorosilane (Si₂H₂Cl₂) is attached to a MOCVD apparatus. A second delivery device from containing germanium tetrachloride : gallium trichloride (GeCl₄ : GaCl₃) formulation according to Example 2 is attached to the MOCVD apparatus. The delivery devices are heated and a carrier gas (H₂ and/or N₂) is passed through each heated delivery device. The carrier gas saturated with vapor phase dichlorosilane and the carrier gas saturated with vapor phase germanium tetrachloride are directed to a deposition chamber containing the sapphire substrate. The deposition chamber is maintained at atmospheric pressure (760 Torr or 101 kPa) and at a temperature sufficient to induce decomposition of the vapor phase compounds (e.g. 1000° C to 1050° C). For this group of layers, a 1 to 2 µm thick Si_{0.90}Ge_{0.10} layer is expected to be first grown on the saphire substrate. Subsequent layers of composition Si_{0.80}Ge_{0.20}, Si_{0.70}Ge_{0.30}, and Si_{0.60}Ge_{0.40} are expected to be grown by increasing the mass flow rate of the germanium tetrachloride. After deposition of the SiₓGe₍₁₋ₓ₎ graded layers, the dichlorosilane flow is continued with the germanium formulation vapor flow completely switched off, in order to obtain abrupt interfaces. Silicon deposition is expected to be carried out using the graded SiGe as the underlying layer, and epitaxial strained silicon layer is deposited as the cap layer. The growth rate in depositing SiₓGe(₁₋ₓ) graded layers is expected to be greater than 0.25 µm/min. Based on the etch pit density (EPD) measurements, the film is expected to have a TDD of < 1 x 10⁴ cm⁻², and pileup density of < 0.5 cm/cm². The short range average surface roughness, as measured by AFM, is expected to be 0.1-0.5 nm (1 to 5 Å).

### Example 4

The following table provides compounds suitable for use as additive compounds in the growth of germanium-containing films according to the present invention and their vapor phase concentrations that are typically used to realize their effectiveness as surface modifier or gas phase modifier or both. These additives may be used under standard CVD film growth techniques currently used to grow strained silicon (e.g. SiGe) films, employing appropriate substrates, e.g., sapphire, silicon, germanium, gallium arsenide and indium phosphide.

| **Reference** | **Additive (mole%)** | **Reference** | **Additive (mole%)** |
|---|---|---|---|
| A | AlCl₃ (0.1) | EE | MgCl₂ (0.25) |
| B | Al(NMe₂)₃ (0.11) | FF | MgBr₂ (0.05) |
| C | AlBr₃ (0.21) | GG | MnCl₄ (0.15) |
| D | Al(Oi-Pr)₃ (0.19) | HH | Mo(EtBz)₂ (0.15) |
| E | SbCl₅ (0.23) | II | MoCp₂ (0.08) |
| F | SbBr₃ (0.01) | JJ | MoCl₄ (0.1) |
| G | t-BuAsH₂ (0.21) | KK | t-BuNH₂ (0.01) |
| H | AsMe₃ (0.14) | LL | Me₂N-NH₂ (0.07) |
| I | AsCl₃ (0.2) | MM | Ni(PF₃)₄ (0.21) |
| J | BEt₃ (0.1) | NN | Ni(EtCp)₂ (0.08) |
| K | B(NMe₂)₃ (0.09) | OO | OsCl₄ (0.09) |
| L | BBr₃ (0.01) | PP | Me₃Pd(MeCp) (0.24) |
| M | Ba(n-PrMe₄Cp)₂ (0.02) | QQ | PCl₃ (0.02) |
| N | BeEt₂ (0.04) | RR | PEt₃ (0.13) |
| O | Be(NMe₂)₂ (0.15) | SS | t-BuPH₂ (0.22) |
| P | BiMe₃ (0.17) | TT | Me₃Pt(MeCp) (0.16) |
| Q | Ca(Me₅Cp)₂(0.25) | UU | Rh(acac)₃(0.25) |
| R | CoCp₂ (0.03) | VV | RuCp₂ (0.1) |
| S | CrCp₂(0.17) | WW | Sr(n-PrMe₄Cp)₂ (0.05) |
| T | Cr(NEt₂)₄ (0.12) | XX | SrCl₂ (0.15) |
| U | ErCp₃ (0.05) | YY | TaCl₅ (0.08) |
| V | FeCp₂ (0.25) | ZZ | Ta(OEt)₅ (0.14) |
| W | GaCl₃ (0.04) | AAA | TiCl₄ (0.25) |
| X | Ga(NMe₂)₃ (0.02) | BBB | Ti(NEtMe)₄ (0.25) |
| Y | Me₂Au(acac) (0.01) | CCC | WBr₆ (0.19) |
| Z | HfCl₄ (0.1) | DDD | VCp₂ (0.18) |
| AA | InCl₃ (0.11 ) | EEE | V(EtCp)₂ (0.1) |
| BB | In(Me₅Cp) (0.13) | FFF | Y(n-BuCp)₃ (0.1) |
| CC | KCl (0.11) | GGG | ZrBr₄ (0.23) |
| DD | n-BuLi (0.25) | HHH | Zr(NMe₂)₄ (0.25) |

In the above table, the following abbreviations are used: Me = methyl, Et = ethyl, n-Pr = n-propyl; i-Pr = iso-propyl; n-Bu = n-butyl; t-Bu = tert-butyl; Cp = cyclopentadienyl; Bz = benzyl; and acac = acetyl acetonate.

## Claims

1. A method of depositing a film comprising germanium on a substrate comprising the steps of:
a) conveying in a gaseous phase a germanium compound and an additive compound chosen from a gas phase modifier and a surface modifier, wherein the germanium compound has the formula GeA₄ wherein each A is independently chosen from hydrogen, halogen, alkyl, alkenyl, alkynyl, aryl, amino, dialkylamino, and dialkylaminoalkyl, to a deposition chamber containing the substrate, and wherein the additive does not comprise germanium;
b) decomposing the germanium compound in the deposition chamber; and
c) depositing the film comprising germanium on the substrate.

2. The method of claim 1 wherein germanium compound and additive compound are provided from a single vapor delivery device.

3. The method of claim 1 wherein the germanium compound is provided from a first vapor delivery device and the additive compound is provided from a second vapor delivery device.

4. The method of claim 1 wherein the germanium compound is a halogermane.

5. The method of claim 1 wherein the additive compound is chosen from silicon compounds, Group IIIA compounds, Group VA compounds, Group IVB compounds, Group VIB compounds, Group VII compounds, tin compounds, lead compounds, hydrogen halides, and hydrido halides of silicon.

6. The method of claim 1 wherein the additive compound is chosen from Group IIIA compounds and Group VA compounds.

7. A vapor delivery device comprising a vessel having an elongated cylindrical shaped portion having an inner surface having a cross-section, a top closure portion and a bottom closure portion, the top closure portion having an inlet opening for the introduction of a carrier gas and an outlet opening, the elongated cylindrical shaped portion having a chamber containing a germanium compound and an additive compound chosen from a gas phase modifier and a surface modifier; the inlet opening being in fluid communication with the chamber and the chamber being in fluid communication with the outlet opening; wherein the germanium compound has the formula GeA₄ wherein each A is independently chosen from hydrogen, halogen, alkyl, alkenyl, alkynyl, aryl, amino, dialkylamino, and dialkylaminoalkyl, and wherein the additive compound does not comprise germanium.

8. The method of claim 7 wherein the additive compound is chosen from silicon compounds, Group IIIA compounds, Group VA compounds, Group IVB compounds, Group VIB compounds, Group VII compounds, tin compounds, lead compounds, hydrogen halides, and hydrido halides of silicon.

9. An apparatus for chemical vapor deposition of metal films comprising the vapor delivery device of claim 7.

10. An apparatus comprising a first vapor delivery device comprising a germanium compound of the formula GeA₄ wherein each A is independently chosen from hydrogen, halogen, alkyl, alkenyl, alkynyl, aryl, amino, dialkylamino, and dialkylaminoalkyl; and a second vapor delivery device comprising an additive compound chosen from a gas phase modifier and a surface modifier, wherein the additive compound does not comprise germanium, the first and second vapor delivery devices capable of providing the germanium compound and the additive compound in the vapor phase to a deposition chamber.

11. A device comprising a germanium-containing layer of the formula MₓGe_{y}, wherein M is a metal or metalloid, x = 0.5 - 0.99, y = 0.01 - 0.5, x + y = 1, wherein the layer has a short range average surface roughness of < 1 nm, and a long range average surface roughness of < 5 nm, and wherein the germanium-containing layer has a threading dislocation density of < 4 x 10⁴ cm⁻² when y = 0.2.
